# FASCICULE DE BREVET EUROPEEN

(11) **EP 1 994 325 B1**
(45) Date de publication et mention de la délivrance du brevet: **21.10.2009**
(21) Numéro de dépôt: 07731146.2
(22) Date de dépôt: 14.03.2007
(51) Int. Cl.: F16M 13/00

(54) **PROCEDE DE MISE EN OEUVRE D'UN SUPPORT INTERCALAIRE UNIVERSEL**
VERFAHREN ZUR VERWENDUNG EINER UNIVERSALZWISCHENSTÜTZE
METHOD OF USING A UNIVERSAL INTERMEDIATE SUPPORT

(30) Priorité: 16.03.2006 FR 0602291
(43) Date de publication de la demande: 26.11.2008
(73) Titulaire: Novatec SA, F-82000 Montauban (FR)
(72) Inventeur: BOURRIERES, Francis, 82000 Montauban (FR); KAISER, Clément, 82000 Montauban (FR)
(86) Numéro de dépôt international: PCT/FR2007/000454
(87) Numéro de publication internationale: WO 2007/104869

(56) Documents cités:
- WO-A-20/05116512
- FR-A- 2 870 318

## Description

### OBJET DE L'INVENTION

La présente invention concerne un procédé et un dispositif de mise en oeuvre d'un système de sustentation ou de maintien universel d'une pièce de forme aléatoire et/ou pouvant être complexe à un niveau de travail déterminé par rapport à une base rigide.

### DOMAINE D'APPLICATION

Le procédé et le dispositif objet de la présente invention permettent de faciliter et d'optimiser la mise en oeuvre d'un dispositif tel que décrit dans les demandes de brevet FR04.05113 et FR04.12165 ainsi que dans l'extension PCT/FR05/01171 du même déposant et inventeur, publiées respectivement sous les numéros FR 2870318, FR 2870319 et WO 2005116512. L'utilisation de la présente invention est particulièrement judicieuse en vue de régler un dispositif de support de cartes électroniques durant leur assemblage sur des machines automatiques de sérigraphie de pose de composants électroniques ou encore de dépose de colle.

### ETAT DE L'ART ANTERIEUR

Selon l'art antérieur décrit dans les demandes de brevets FR04.05113 et FR04.12165, le réglage du support universel de cartes électroniques est obtenu par la mise en contact et l'appui du produit à supporter sur le support universel, puis une dépression est appliquée dans une enceinte étanche qui a pour effet de figer le support en l'état. L'appui de la pièce à supporter sur le support permet d'écraser un corps élastique et ainsi de faire épouser la forme du produit à supporter par l'enceinte. Lorsque la pièce à supporter est une carte électronique, il est recommandé d'appuyer sur le dessus de la carte à l'aide d'une plaque plane afin de redresser la carte préalablement à l'application du vide dans l'enceinte. L'utilisation d'une telle plaque d'appui et l'effort qu'elle implique est certaines fois inacceptable. Sur certains équipements, l'effort est trop important et peut conduire à surélever le produit par rapport à la hauteur de travail souhaitée.

### INVENTION

L'objet de la présente invention est de faciliter la mise en oeuvre du dispositif support universel décrit dans la demande de brevet PGT/FROS/O1171. En particulier, la présente invention vise à diminuer voire à supprimer l'effort d'appui du produit à supporter sur le support universel par rapport au niveau de référence en position travail et préalablement au conformage du produit sur les enceintes déformables. Le support universel étant constitué d'un ou de plusieurs modules présentant au moins une enceinte déformable, étanche, remplie de particules et reliée à une source de dépression par un orifice et ladite enceinte présente une zone concave disposée au moins partiellement entre l'enceinte déformable et la table sur laquelle le support repose. La forme concave de l'enceinte déformable est en fait un volume libre qui est disposé entre l'enceinte déformable et la table de l'équipement. Lorsqu'une pièce est appliquée sur l'enceinte déformable ce volume est diminué par écrasement et permet ainsi à l'enceinte déformable d'épouser les formes du produit à supporter. Le corps élastique permet de repousser l'enceinte déformable dans sa position initiale lorsque la dépression est annulée dans l'enceinte. Pour la présente invention il est impératif de constituer une chambre formée partiellement ou en totalité par la forme concave et connectable à une source de dépression. Par rapport au procédé de mise en oeuvre décrit dans l'art antérieur, le conformage de l'enceinte déformable est réalisé sans déformation donc pratiquement sans contrainte exercée sur le circuit ou l'objet à supporter. Dans l'art antérieur, la recherche du niveau de position travail est effectué en exerçant une pression sur le circuit du haut vers le bas en direction de l'enceinte étanche, celle-ci opposant une réaction de déformation importante qui est la somme de l'effort de déformation de la chambre concave mais surtout de l'effort de déplacement des particules mobiles dans l'enceinte étanche venant parfaitement épouser les formes à supporter. Or dans la présente invention, la recherche du niveau de position travail est obtenue en positionnant préalablement le circuit dans cette position de référence tout en maintenant le vide dans la chambre concave élastique, seulement ensuite le vide de la dite chambre est supprimé et ainsi cette dernière provoque un déplacement de l'enceinte du bas vers le haut jusqu'au contact avec le circuit constituant le plan de référence de travail. De cette façon, l'effort exercé sur le circuit n'est égal qu'à la réaction de la chambre concave élastique sachant que l'effort lié au déplacement des particules mobiles dans l'enceinte étanche est nul. Dans ce cas de figure, même si le conformage autour des parties en saillie est moindre, il est suffisant pour ensuite opposer une surface de contact acceptable en position de travail.

L'invention se caractérise essentiellement en ce qu'elle consiste à la succession des étapes suivantes:
- application d'une dépression dans la chambre formée par la zone concave de manière à provoquer l'écrasement de ladite zone concave et du corps élastique et provoque par entraînement l'affaissement de l'enceinte déformable. Ainsi selon l'invention, l'écrasement de l'enceinte déformable et de la zone concave n'est plus obtenu par l'appui de la pièce. à supporter sur l'enceinte provoqué par la contrainte préalable à la déformation de ladite enceinte, mais par la dépression réalisée dans la chambre qui a pour effet de comprimer le corps élastique et de réduire le volume de la chambre ce qui entraîne un abaissement significatif du niveau supérieur permettant ainsi de positionner le circuit sans contrainte sans la position de référence.
- Mise en place de la pièce à supporter. Généralement la mise en place s'effectue de manière automatique par le biais du système de convoyage équipant les machines automatiques.
- Annulation de la dépression dans la chambre de façon à ce que le corps élastique se détende et pousse l'enceinte déformable en contact avec la pièce à supporter et fasse ainsi épouser les formes de la pièce à l'enceinte déformable. Ainsi contrairement à l'état de l'art antérieur où il est nécessaire d'appuyer sur le produit à supporter pour déformer l'enceinte déformable ainsi que le corps élastique présent dans la forme concave, avec la présente invention on utilise l'élasticité du corps élastique présent dans la zone concave pour pousser l'enceinte déformable en contact avec la pièce à supporter en épousant ses formes. Par conséquent l'effort appliqué sur la pièce est bien moindre. En effet, selon l'art antérieur, l'effort nécessaire pour former l'enceinte déformable est la somme des efforts nécessaires pour vaincre les efforts de frottements des particules présentes dans l'enceinte déformable et des efforts nécessaires pour écraser le corps élastique présent dans la forme concave. Grâce à la présente invention, l'effort qui s'applique sur le produit à supporter est la différence entre l'effort généré par la détente du corps élastique et l'effort de frottement des particules.
- Application d'une dépression dans l'enceinte déformable de manière à figer l'enceinte pour la durée de l'opération d'assemblage ou de traitement.

Selon une autre caractéristique, l'invention concerne un dispositif de mise en oeuvre selon la revendication 2.

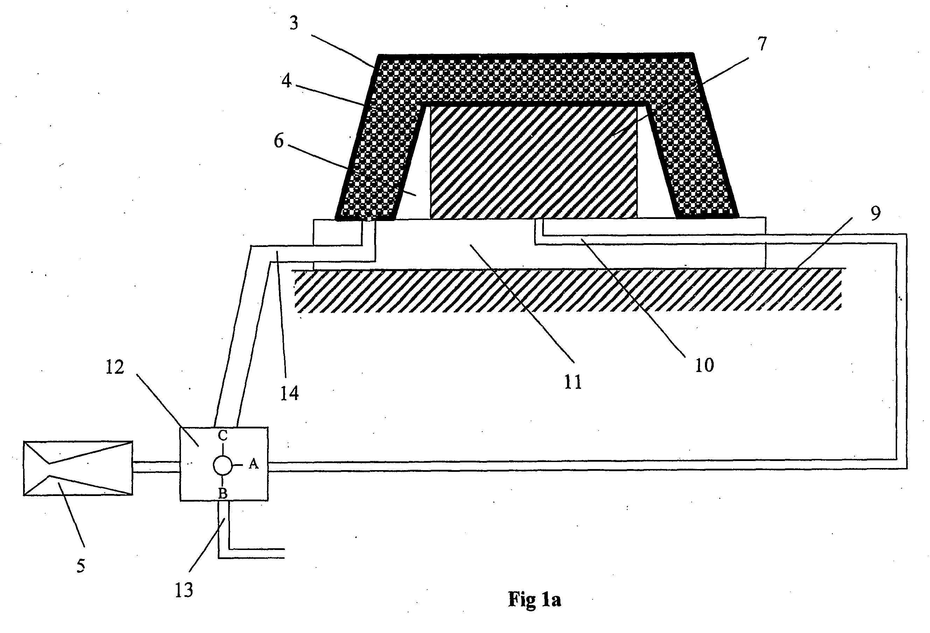

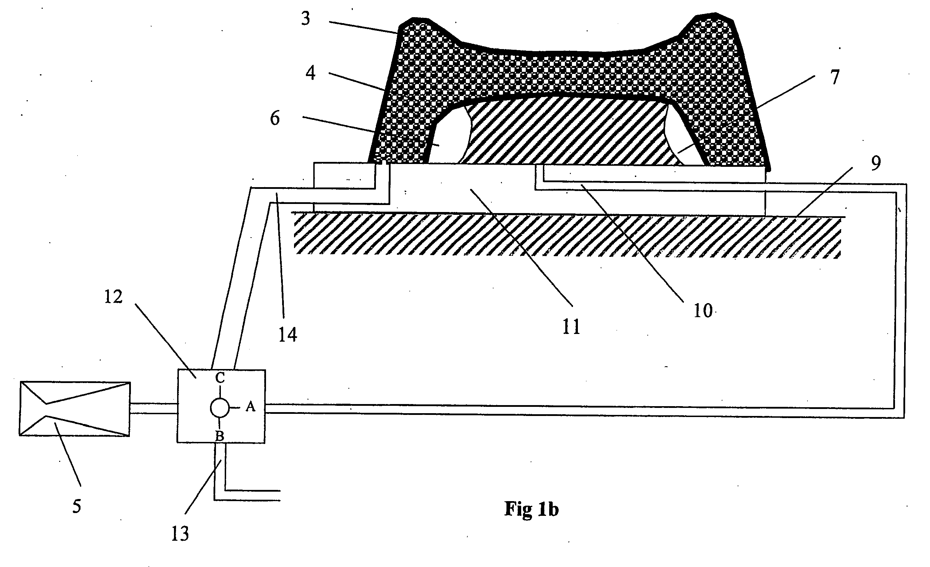

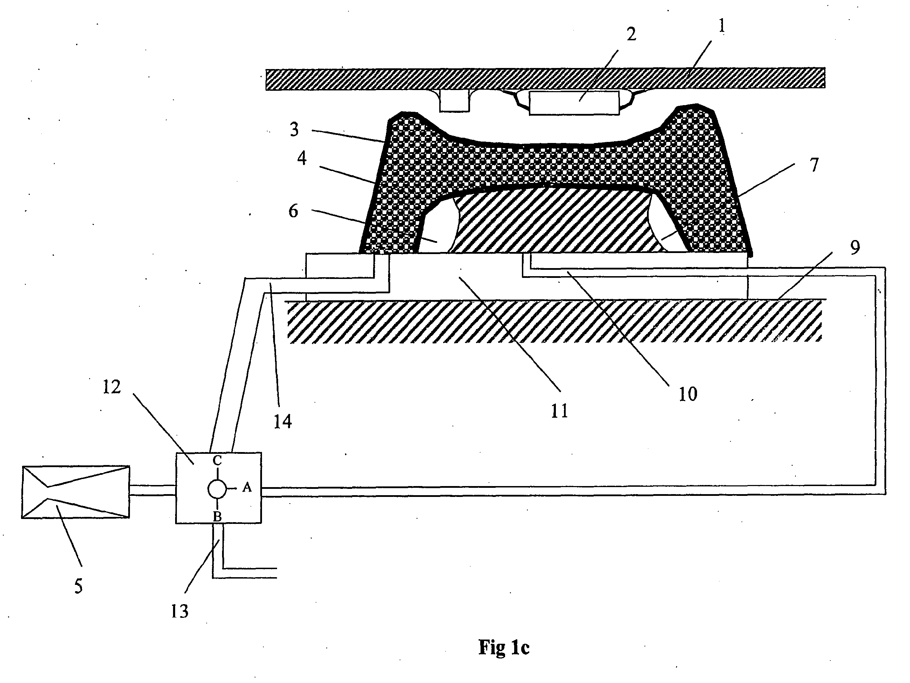

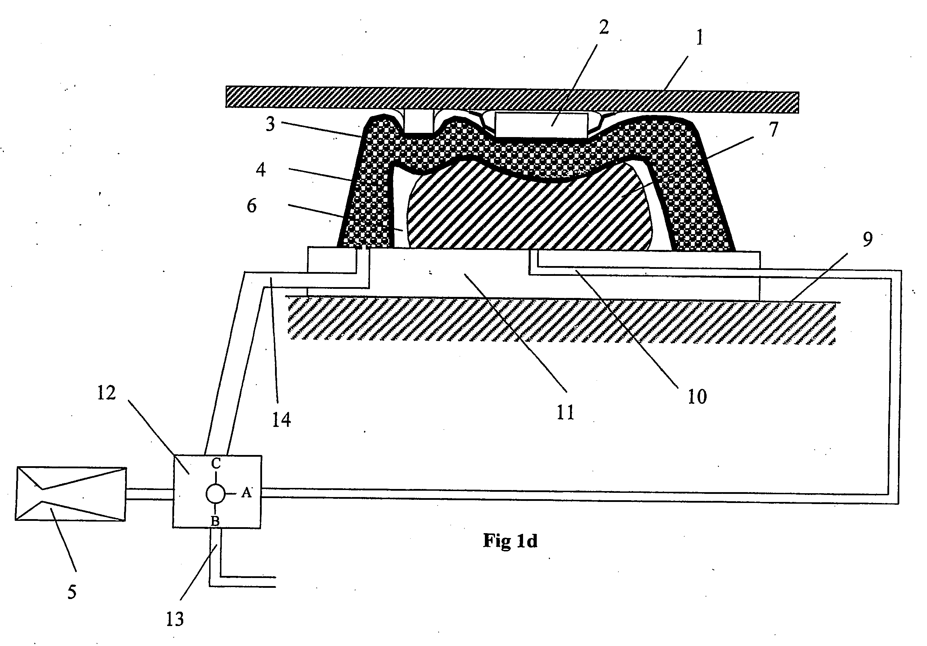

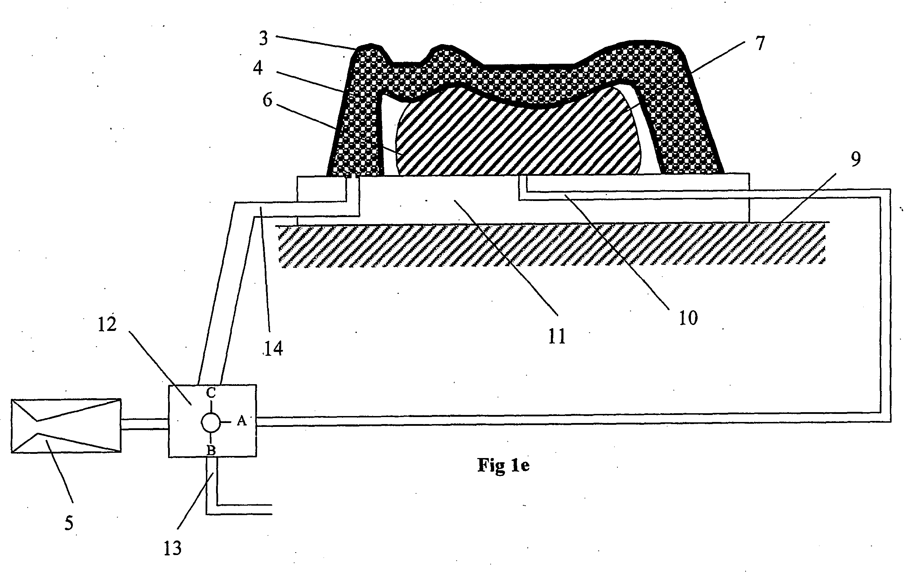

En figure 1 est montrée la mise en oeuvre du procédé et du dispositif de la présente invention. Le dispositif support est constitué d'au moins une enceinte étanche et déformable (3), contenant des particules (4) et présentant une forme concave. Cette forme concave est disposée entre la table support (9) et l'enceinte déformable (3) grâce à la plaque de base (11) la forme concave forme une chambre (6) comblée partiellement par un corps élastique (7) et connectable à une source de dépression par (10). Le dispositif objet de la présente invention est constitué d'au moins une source de vide (5) et d'un sélecteur à au moins trois positions (12).

En figure 1a, le dispositif support est montré en position repos.

En figure 1b, le sélecteur (12) est en position A, ainsi la chambre (6) est reliée à la source de vide (5) par le biais de (10). La dépression dans la chambre (6) a pour effet de diminuer le volume de la chambre, d'écraser le corps élastique qui typiquement est une mousse à cellules ouvertes et d'affaisser l'enceinte déformable (3).

En figure 1c, la pièce à supporter est mise en position de travail. Dans le cas représenté, la pièce à traiter est une carte électronique (1) déjà équipée de composants (2) sur la face inférieure. Généralement la carte est amenée en position de travail par un convoyeur non représenté.

En figure 1d, le sélecteur (12) est mis en position B, ce qui a pour effet de relier la chambre (6) et l'enceinte (3) à l'échappement (13). Le fait de supprimer la dépression dans la chambre (6) provoque la détente du corps élastique (7) ce qui a pour effet de pousser l'enceinte (3) en contact avec la pièce à supporter en épousant ses formes. Pour garantir la parfaite planéité de la carte (1), il peut être judicieux de placer une plaque plane sur la face supérieure, mais dans la majorité des cas, cela n'est pas nécessaire. Une fois que l'enceinte (3) a épousé les formes de la pièce à supporter, le sélecteur est mis en position C ce qui a pour effet de relier la source de dépression (5) à l'intérieur de l'enceinte déformable. Ainsi, l'enceinte (3) se fige en l'état et maintient parfaitement la pièce à supporter pour la durée de l'opération à effectuer sur la pièce.

En figure le, la carte (1) a été évacuée mais la forme de la carte est mémorisée et maintenue en vue de traiter la carte suivante.

Dans le cas représenté sur la figure 1, une seule source de dépression (5) est représentée pour réaliser la dépression dans la chambre (6) ainsi que dans l'enceinte déformable (3) mais il est envisageable d'utiliser deux sources de dépression distinctes.

Selon une autre caractéristique, le dispositif de support est formé pour chaque carte qui se présente sur la machine.

La figure 1 montre une seule enceinte déformable mais il est évident que le procédé s'applique également si plusieurs enceintes sont juxtaposées pour s'adapter à la largeur de carte.

## Revendications

1. Procédé de mise en oeuvre d'un support universel constitué d'un ou plusieurs modules présentant une enceinte (3) déformable, étanche, remplie de particules (4) et reliée à une source de dépression (5) par un orifice, et ladite enceinte présente une zone concave formant une chambre (6) pourvue d'un corps élastique (7) pouvant s'écraser et assurant un retour en position initiale au repos, **caractérisé en ce qu'**il consiste à la succession des étapes suivantes:
- application d'une dépression dans la chambre (6) de manière à provoquer l'écrasement de la zone concave et du corps élastique (7) entraînant l'affaissement de l'enceinte déformable (3)
- mise en place de 1a pièce à supporter,
- annulation de la dépression dans la chambre (6) de façon à ce que le corps élastique (7) se détende et pousse l'enceinte déformable (3) en contact avec la pièce à supporter,
- application d'une dépression dans l'enceinte déformable (3) de manière à la figer.

2. Dispositif de mise en oeuvre d'un support universel constitué d'un ou plusieurs modules présentant une enceinte (3) déformable, étanche, remplie de particules (4) et reliée à une source de dépression (5) par un orifice, et ladite enceinte présente une zone concave formant une chambre (6) pourvue d'un corps élastique (7) pouvant s'écraser et assurant un retour en position initiale au repos, comportant un dit support et au moins une source de dépression (5) et **caractérisé en ce qu'**il comporte un sélecteur à au moins trois positions, la première reliant la source de dépression (5) à l'intérieur de la chambre (6), la deuxième assurant la mise à l'échappement de la chambre (6) et de l'enceinte (3) et la troisième reliant la source de dépression (5) à l'enceinte (3).

## Claims

1. Method of using a universal support consisting of one or more modules having a deformable, sealed enclosure (3), filled with particles (4) and connected to a vacuum source (5) through an orifice, and said enclosure has a concave area forming a chamber (6) provided with an elastic body (7) that can be crushed and assuring a return to the initial position at rest, **characterised in that** it consists of the following succession of steps:
- applying a vacuum to the chamber (6) so as to cause the crushing of the concave area and the elastic body (7) leading to the collapse of the deformable enclosure (3),
- positioning the part to be supported,
- breaking the vacuum in the chamber (6) so that the elastic body (7) relaxes and pushes the deformable enclosure (3) into contact with the part to be supported,
- applying a vacuum to the deformable enclosure (3) so as to immobilise it.

2. Device for using a universal support consisting of one or more modules having a deformable, sealed enclosure (3), filled with particles (4) and connected to a vacuum source (5) through an orifice, and said enclosure has a concave area forming a chamber (6) provided with an elastic body (7) that can be crushed and assuring a return to the initial position at rest, comprising a said support and at least one vacuum source (5) and **characterised in that** it comprises a selector with at least three positions, the first connecting the vacuum source (5) to the inside of the chamber (6), the second assuring the venting from the chamber (6) and the enclosure (3) and the third connecting the vacuum source (5) to the enclosure (3).

## Patentansprüche

1. Verfahren zur Verwendung eines universellen Trägers, der aus einem oder mehreren Modul(en) besteht, umfassend ein verformbares, dichtes Gehäuse (3), das mit Partikeln (4) gefüllt ist und durch eine Öffnung mit einer Unterdruckquelle (5) verbunden ist, wobei das Gehäuse eine konkave Zone aufweist, die eine Kammer (6) bildet, die mit einem elastischen Körper (7) ausgestattet ist, der sich komprimieren kann und eine Rückkehr in die Ausgangsposition im Ruhezustand gewährleistet, **dadurch gekennzeichnet, dass** es aus der Aufeinanderfolge der folgenden Stufen besteht:
- Anlegen eines Unterdrucks in der Kammer (6) derart, dass das Zusammendrücken der konkaven Zone und des elastischen Körpers (7) hervorgerufen wird, was das Einfallen des verformbaren Gehäuses (3) mit sich bringt;
- Anordnen des zu tragenden Teils;
- Rückgängigmachen des Unterdrucks in der Kammer (6) derart, dass sich der elastische Körper (7) ausdehnt und das verformbare Gehäuse (3) mit dem zu tragenden Teil in Kontakt drückt;
- Anlegen eines Unterdrucks in dem verformbaren Gehäuse (3) derart, dass es festwerden gelassen wird.

2. Vorrichtung zur Verwendung eines universellen Trägers, der aus einem oder mehreren Modul(en) besteht, umfassend ein verformbares, dichtes Gehäuse (3), das mit Partikeln (4) gefüllt ist und durch eine Öffnung mit einer Unterdruckquelle (5) verbunden ist, wobei das Gehäuse eine konkave Zone aufweist, die eine Kammer (6) bildet, die mit einem elastischen Körper (7) ausgestattet ist, der sich komprimieren kann und eine Rückkehr in die Ausgangsposition im Ruhezustand gewährleistet, umfassend einen derartigen Träger und wenigstens eine Unterdruckquelle (5) und **dadurch gekennzeichnet, dass** sie eine Auswahlvorrichtung mit wenigstens drei Positionen umfasst, wobei die erste die Unterdruckquelle (5) mit dem Inneren der Kammer (6) verbindet, die zweite die Durchführung des Ausströmens aus der Kammer (6) und dem Gehäuse (3) sicherstellt und die dritte die Unterdruckquelle (5) mit dem Gehäuse (3) verbindet.
